# EUROPEAN PATENT SPECIFICATION

(11) **EP 1 597 315 B1**
(45) Date of publication and mention of the grant of the patent: **01.08.2007**
(21) Application number: 04713324.4
(22) Date of filing: 20.02.2004
(51) Int. Cl.: C08L 63/00, C08G 65/10, B32B 27/38, H01L 29/12

(54) **MOLDING COMPOSITIONS CONTAINING QUATERNARY ORGANOPHOSPHONIUM SALTS**
QUATERNÄRE ORGANOPHOSPHONIUMSALZE ENTHALTENDE FORMMASSEN
COMPOSITIONS DE MOULAGE CONTENANT DES SELS D'ORGANOPHOSPHONIUM QUATERNAIRES

(30) Priority: 20.02.2003 US 369916
(43) Date of publication of application: 23.11.2005
(73) Proprietor: Henkel Corporation, Rocky Hill, Connecticut 06067 (US)
(72) Inventor: GALLO, Anthony, A., Olean, NY 14760 (US); DIMKE, Mark, T., Olean, NY 14760 (US); AHSAN, Tanweer, Olean, NY 14760 (US)
(74) Representative: Lane, Cathal Michael
(86) International application number: PCT/US2004/005029
(87) International publication number: WO 2004/074366

(56) References cited:
- EP-A- 0 360 195
- EP-A- 0 978 542
- US-B1- 6 255 365
- FLICK E.W.: 'Plastic additives', September 2001 page 243, XP008066613

## Description

### RELATED APPLICATION DATA

This application claims the benefit of an earlier filing date under 35 U.S.C. §120 from United States Patent Application No. 10/369,916.

### BACKGROUND OF THE INVENTION

### Field Of The Invention

The present invention relates to molding compounds for electrical and electronic devices, particularly epoxy-based compounds exhibiting reduced gate leakage current, flame resistance, moisture resistance, and low warpage and shrinkage.

### Brief Description of Related Technology

Epoxy resins are widely used in molding compounds for coating electrical and electronic devices. Such epoxy molding compounds used for encapsulation are generally prepared from a blend of an epoxy resin and phenol hardener, along with other ingredients including fillers, catalysts, flame retardant materials, processing aids and colorants. Epoxy resins in such molding compounds are traditionally diepoxides which include two epoxy groups per molecule, which are reacted with a co-reactant (cross-linking agent or hardener) consisting of acid dianhydride, diamine or diphenol oligomers. Diphenol oligomers such as those derived from novolac phenols, cresol phenols and bisphenol A are particularly preferred in the art as hardeners due to their high reliability.

Flame retardants in epoxy compositions are typically provided for the safety of the assembler and/or the end user. A common flame retardant system is a combination of bromine-containing flame retardants and antimony oxide flame retardant synergists. However, these compounds are pollutants of the environment. Some bromine-containing flame retardants (especially brominated diphenyl ethers) are toxic and possibly carcinogenic. Antimony trioxide is classified by the International Agency for Research on Cancer as a Class 2B carcinogen (i.e., antimony trioxide is a suspect carcinogen based mainly on animal studies). In addition, this compound is often used at a relatively high level (2-4 %) and is also slightly water-soluble, leading to further environmental concerns. This concern is highlighted by the fact that integrated circuit manufacturers currently discard up to one half of the total amount of molding compositions used.

Phosphorus-containing compounds have been proposed as flame retardants. For example, U.S. Patent No. 5,739,187 discloses epoxy resin compositions as semiconductor encapsulants which include a phosphorus-containing flame retardant to eliminate the use of antimony trioxide and brominated compounds. However, molding compositions containing conventional phosphorus compounds generally possess undesirable properties such as high moisture absorption, which can cause stress and cracking of the encapsulant at elevated temperatures.

Melamine cyanurate is commonly sold as a flame retardant compound. Although effective as a flame retardant, high levels of this material has been observed to adversely reduce the flowability of molding compounds. As a result, it has been impractical to incorporate melamine cyanurate into molding compounds at appropriate levels for both adequate flame retardancy while maintaining flowability.

Unfortunately, reducing the amount of the flame retardant to address such issues compromises flame retardance, with the molding compounds failing to meet the well-recognized flame retardance standard, UL-94 V-O rating.

Another challenge to formulators of molding compounds for electrical and electronic devices is to provide flame resistance while maintaining acceptable physical properties such as long flow and low warpage and shrinkage. U.S. Patent No. 5,434,199 discloses a low stress epoxy molding composition which includes a tris-phenolmethane multifunctional epoxy resin in combination with a tris-phenolmethane multifunctional phenolic hardener, along with silicone rubber powder and an organofunctional silicone fluid. The organofunctional silicone fluid is provided to provide flowability to the molding compound.

Yet a further challenge in the development of molding compounds for electrical and electronic devices is the concern over gate leakage. Electro-thermally Induced Parasitic Gate Leakage (GL) is an environment and material induced failure mechanism that adversely affects the performance and reliability of an integrated circuit. Circuit sensitivity is affected by circuit/chip design, physical layout, the fabrication process and the electrical characteristics of the encapsulation material. GL occurs at elevated temperatures in the presence of an electrical field or static charge. The GL effect is similar to charging a capacitor through a variable resistance. When the integrated circuit is subjected to an ionizing voltage field the die acts like a capacitor and accumulates and stores charge. This then leads to a change in the integrated circuit's impedance resulting in a circuit logic failure.

Unfortunately, GL results in yield losses during high temperature processes, especially those with heated air flow such as high temperature handling and IR reflow solder operations. The GL sensitivity is affected by the circuit design, as well as by the encapsulation material and the curing process for encapsulating the circuit.

It would be desirable to provide new flame retardant molding compositions that overcome the disadvantages of the prior art such as environmental concerns and high moisture absorption, while providing acceptable physical properties. Moreover, it would be desirable to provide molding compositions with excellent stress characteristics such as low warpage and shrinkage with improved flowability upon curing.

### SUMMARY OF THE INVENTION

The present invention provides a composition, and in particular a molding compound, including an epoxy resin; a curing agent for the epoxy resin; and a catalyst for promoting reaction of the epoxy resin and the curing agent, with the catalyst including a quaternary organophosphonium salt. In a particular embodiment, the quaternary organophosphonium salt is present in at least an amount sufficient to catalytically effect crosslinking of the epoxy resin and the curing agent when the composition is heated to a temperature of at least 135°C. The composition is particularly suitable for use as a molding compound, and may further include a flame retardant compound, such that the molding composition exhibits improved flame resistance after curing thereof, compared to a similar composition that does not contain the quaternary organophosphonium salt.

The quaternary organophosphonium salt is desirably an organophosphonium functional acetic acid ester compound such as ethyl triphenyl phosphonium acid acetate, and the flame retardant compound desirably includes a melamine cyanurate. It has been discovered that the combination of the quaternary organophosphonium salt with the melamine cyanurate provides a synergistic effect to improve the flame retardancy of the compound, with the quaternary organophosphonium salt also catalyzing the reaction of the epoxy resin and the curing agent (hardener).

It has also been discovered that the use of the quaternary organophosphonium salt as the catalyst reduces electro-thermally induced parasitic gate leakage in semiconductor integrated circuit parts molded with such molding compositions. Desirably, the catalyst further includes a tertiary amine such as 1,8-diazabicyclo[5.4.0]undec-7-ene in combination with the quaternary organophosphonium salt.

For purposes of the present invention, the phrase "degree of branching" is meant to describe the number of aromatic groups that are connected through a central carbon atom or a small cluster of carbons, such as a cluster of 2-5 carbons.

In a further embodiment of the invention, the epoxy resin includes a multifunctional epoxy resin derived from phenol and having a degree of branching of at least three, and the curing agent is derived from phenol and has a degree of branching of at least three. Such a composition exhibits reduced warpage and shrinkage when used as a molding composition. A particular desirable composition includes an epoxy resin derived from trisphenol methane and a hardener derived from trisphenol methane.

Also provided is an encapsulant for an electrical or electronic device, as well as a method for coating an electrical or electronic device. The method includes providing a molding composition as set forth above; contacting a surface of the device with the molding composition; and heating the molding composition to a temperature sufficient to cure the molding composition and form a polymer on the surface of the device.

As used herein, a molding composition is cured when it forms a good cull cure, indicating a cured molding part which has no bubbles, cracks or bumps on the surface, and has good physical integrity, in that it does not crumble as judged by a technician by breaking it with their hands (i.e., strong and not brittle).

Other features and advantages of the invention will be apparent from the description of the preferred embodiments thereof, and from the claims.

### DETAILED DESCRIPTION OF THE INVENTION

The present invention is directed to a composition of matter, and in particular to a molding compound such as for use in encapsulating electronic packages such as semiconductor devices. In general, the molding compound includes an epoxy resin and a curing agent for the epoxy resin, as well as a specific type of catalyst to promote crosslinking between the epoxy resin and the curing agent. As will be discussed in further detail herein, the catalyst is a salt of a quaternary organophosphonium compound, which advantageously reduces susceptibility to GL of integrated circuits. Additionally, the quaternary organophosphonium compound provides improved properties to the molding composition with respect to flame retardance, flowability, warpage and shrinkage.

A typical molding composition as provided by the present invention comprises an epoxy resin; a curing agent for the epoxy resin; and a quaternary organophosphonium salt. The composition may further include a flame retardant compound. Typically the composition is essentially free of bromine and antimony compounds.

There is no restriction on the type of epoxy resin that can be used in the molding compositions so long as at least a portion of the epoxy resin used contains two or more reactive oxirane groups. For example, the epoxy resin may be selected from, but not limited to, bisphenol A type epoxy resins, novolac type epoxy resins such as epoxy cresol novolac resin and phenolic novolac epoxy resin, alicyclic epoxy resins, glycidyl type epoxy resins, biphenyl epoxy resins, naphthalene ring-containing epoxy resins, cyclopentadiene-containing epoxy resins, polyfunctional epoxy resins, hydroquinone epoxy resins, and stilbene epoxy resins. The molding compositions can include more than one epoxy resin, for example, a combination of epoxy cresol novolac resin and biphenyl epoxy resin.

As noted, bisphenol and biphenyl epoxy resins, which are traditionally referenced as di-epoxies, and epoxy cresol novolac resins, which are traditionally referenced as multifunctional epoxies, are useful in the present invention. Such epoxies have a degree of branching of two, in that two phenolic groups having pendant epoxies are linked through the same carbon atom. For example, diglycidyl ether of bisphenol A is difunctional, including two phenolic groups with pendant epoxies extending from a central carbon atom. It therefore has a degree of branching of two. Epoxy cresol novolac resins are oftentimes referenced as "multifunctional", in that they are polymeric compounds with a plurality of pendant epoxy moieties which may extend from the polymeric chain. For example, epoxy cresol novolac resins include the following structure:

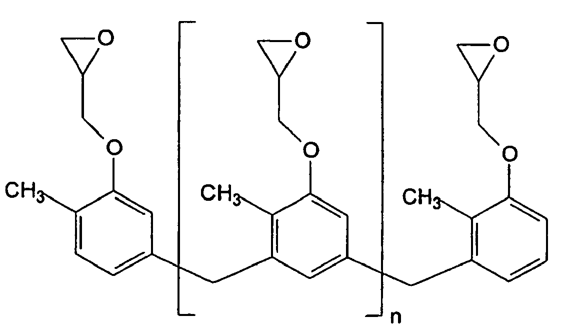

In the instance where n=0, the functionality if this structure would be 2. If n=1, the functionality, is 3, if n=4, the functionality is 4, etc. As such, this compound is traditionally referred to as a multifunctional epoxy resin. However, since only two phenolic groups extend from the same carbon or small cluster of carbons, the degree of branching of this type of resin would be equal to two.

In a particularly desirable embodiment, the epoxy resin is a multifunctional epoxy resin having a degree of branching within the resin backbone of at least three. Thus, particularly desirable multifunctional epoxy resins are those derived from phenol and which include at least three phenolic groups branching directly from the same central carbon atom or central cluster of carbons, with a pendant oxirane group linked to each of the at least three phenolic groups.

Non-limiting examples of useful multifunctional epoxy resins having a degree of branching of at least three include: 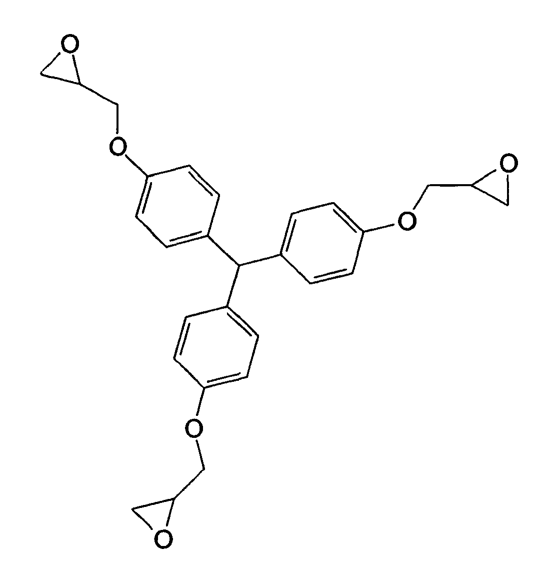 triphenylol methane triglycidyl ether (having a degree of branching of three, represented by three terminal glycidyl ether moieties branching from a central carbon atom); and 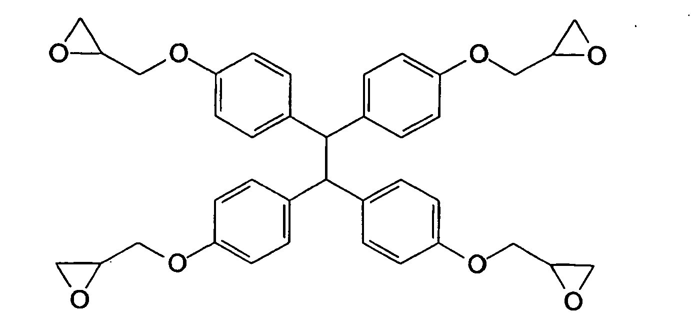 tetra glycidyl ether of tetra phenol ethane (having a degree of branching of four, represented by four terminal glycidyl ether moieties branching from a central two carbon cluster ethyl moiety).

Particularly desirable are epoxy resins derived from tris-phenolmethane, such as triphenylol methane triglycidyl ether.

The multifunctional resin having a degree of branching of at least three may be used alone, or in combination with conventional resins such as those described above.

The epoxy resin typically has a theoretical epoxy equivalent weight of about 150 to 250. The epoxy resin is typically present in the composition of the present invention in an amount of about 1 to 25 percent by weight, often 4 to about 12 percent by weight, and more often, from about 5.5 to about 8.5 percent by weight, based on the total weight of the composition.

The curing agent (hardener) promotes crosslinking of the molding composition to form a polymer composition upon heating of the composition to a temperature of at least 135°C. Some suitable curing agents that can be included in the molding compositions of the present invention are phenol novolac type hardener, cresol novolac type hardener, dicyclopentadiene phenol type hardener, limonene type hardener, and anhydrides. Flexible hardeners having a hydroxyl equivalent weight greater than about 150 are often desirable, such as xylock novolac type hardener. Non-limiting examples of flexible hardeners include bisphenol M commercially available from Borden Chemical, and DEH 85, commercially available from Dow Chemical. Similar to the epoxy resin, more than one type of curing agent can be included in the molding compositions.

As with the epoxy resin, multifunctional hardeners having a degree of branching of at least three are particularly desirable in one embodiment of the present invention. Particularly desirable are those derived from tris-phenol and which contain at least three functional groups that are reactive with epoxide groups.

The curing agent is typically present in the composition of the present invention in an amount of about 1 percent by weight to about 10 percent by weight, often from about 1.5 percent by weight to about 6 percent by weight, based on the total weight of the composition.

The composition further includes a catalyst for promoting reaction of the epoxy resin and the hardener. Traditionally, such epoxy compositions incorporate catalysts such as tertiary amines, substituted phosphines, imidazoles, and the like, with compounds such as 1,8-diazabicyclo[5.4.0]undec-7-ene ("DBU"), dicyandiamide ("DICY") and triphenylphosphine ("TPP") being particularly well known for use as catalysts.

It has been discovered through the present invention that salts of quaternary organophosphonium compounds are particularly useful as catalysts for epoxy compositions for use in molding compounds. Such compounds are represented by the formula: 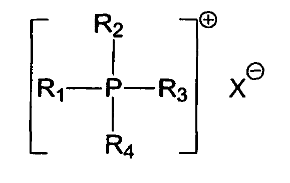 where R₁, R₂, R₃ and R₄ are C₁₋₈ akyl or aryl groups and X is halogen, acetate or phosphate anion. Desirably, the anion is acetate, and at least one of R₁, R₂, R₃ and R₄ is a phenyl group and at least one of R₁, R₂, R₃ and R₄ is methyl, ethyl, propyl or butyl. Organophosphonium functional acetic acid ester compounds are particularly desirable, such as ethyltriphenylphosphonium acid acetate complex ("EtTPPOAc"), commercially available from Rohm and Haas.

It has also been discovered through the present invention that integrated circuits encapsulated within molding compounds including such a quarternary organophosphoium salt provide for a reduction in electro-thermally induced parasitic gate leakage in the integrated circuit. GL is similar to other trapped charge and mobile ion phenomena in that it occurs at elevated temperatures in the presence of an electrical field or static charge. It is known that extended curing of a molding composition after an encapsulation procedure significantly improves part tolerance and resistance to GL. It has been discovered through the present invention, however, that such extended post mold curing is not required to improve resistance to GL when specific catalysts are used in the molding compound, and in particular, specific combinations of catalysts. It is speculated that the cure properties of the molding compounds including the specific catalysts of the present invention restrict the mobility of ions within the polymeric matrix at higher temperatures, thereby reducing the accumulation of charge in the package.

As indicated, EtTPPOAc had been found to be particularly useful as the quaternary organophosphonium salt catalyst in the present invention. It has further been discovered that catalyst systems including such a quarternary organophosphonium salt in combination with other traditional catalysts provide further improvements and reduction in GL. In particular, catalyst systems including the quarternary organophosphonium salt in combination with one or more traditional catalysts, such as tertiary amines, have been found to be particularly useful in reducing GL in circuits. A particularly useful tertiary amine is DBU, identified by the following structure:

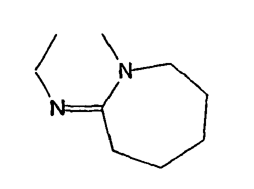

Such catalyst systems comprised of a combination of a quarternary organophosphonium salt and a tertiary amine, for example EtTPPOAc and DBU, provide for a synergistic effect, providing a reduction in GL as compared with prior art molding compounds incorporating traditional catalysts, and molding compounds incorporating either the EtTPPOAc or the DBU alone.

Additionally, it has further been discovered through the present invention that molding compounds including such a quaternary organophosphonium salt provide improved flame resistance when compared to similar compositions that do not contain a quaternary organophosphonium salt. For example, in traditional epoxy compositions incorporating only a traditional catalyst such as DBU or TPP, a significant amount of a flame retardant component must be included within the composition to impart flame resistance to the composition. Such traditional flame retardants, however, can deleteriously affect the molding compound, such as by reducing the flowability. It has been unexpectedly discovered through the present invention that epoxy compositions including a quaternary organophosphonium salt, such as a phosphonium functional acetic acid ester compound, exhibit improved flame resistance as compared with similar compositions that do not include a quaternary organophosphonium salt. As such, flame retardant epoxy compositions, and in particular, flame retardant epoxy molding compositions, can be prepared with reduced levels of traditional catalysts and with reduced levels of conventional flame retardant compounds, thereby reducing or eliminating any deleterious effect from the additional flame retardant compounds.

The catalyst system including the quaternary organophosphonium salt is present in the composition of the present invention at least in an amount sufficient to catalytically effect crosslinking of the epoxy resin and curing agent when the composition is heated to a temperature of at least 135°C. Desirably, the quaternary organophosphonium salt is present in the composition at least in an amount sufficient to provide improved flame resistance to the composition after curing thereof, compared to a similar composition that does not contain a quaternary organophosphonium salt. Flame resistance may be measured using any acceptable testing method known to those skilled in the art. A suitable test method is UL 94, with an acceptable rating of V-1 or V-O. Moreover, the quaternary organophosphonium salt is desirably present in the composition at least in an amount sufficient to provide for a reduction in gate leakage when the composition is used for encapsulation of a circuit chip. Gate leakage may be measured using any acceptable testing method known to those skilled in the art. A suitable test method is described by the Automotive Electrical Counsel's AEC-Q100-006.

Desirably, the total amount of catalyst present in the molding compound is from about 0.1 to about 1 percent, based on the total weight of the molding compound. In particularly useful catalyst systems in accordance with the present invention, catalyst includes the organophosphonium salt in amounts from about 25 percent to about 100 percent of the total catalyst present in the composition, with the balance being a tertiary amine such as DBU. Particularly desirable catalyst systems include equal proportions of the organophosphonium salt and a tertiary amine within the total amount of catalyst present in the molding composition.

In addition, the composition of the present invention may further include a component specifically designated for imparting flame retardancy to the composition. Non-limiting examples of suitable flame retardants include, but are not limited to, cyanurate functional compounds such as melamine cyanurate, transition metal oxides such as tungsten trioxide, molybdenum trioxide, zinc molybdate, calcium molybdate, zinc borate, zinc oxide and mixtures thereof. Melamine cyanurate is particularly desirable. The flame retardant is desirably present in the composition of the present invention in a total amount of up to about 5 percent by weight based on the total weight of the composition. When melamine cyanurate is used as the flame retardant, it is typically present in amount less than or including about 3.0 percent by weight. Combinations of flame retardant materials may also be provided with a particularly desirable combination comprising melamine cyanurate in an amount of about 3.0 percent by weight, zinc borate in an amount of about 0.5 percent by weight, and zinc oxide in an amount of about 0.4 percent by weight.

A particularly desirable composition of the present invention includes melamine cyanurate in combination with a quaternary organophosphonium salt, an epoxy resin and a hardener for the epoxy resin. It has been discovered that the use of the quaternary organophosphonium salt, and in particular a phosphonium functional acetic acid ester compound, as a catalyst in such a composition improves the flame retardance of the composition, particularly in combination with a melamine cyanurate flame retardant. Therefore, the amount of melamine cyanurate can be decreased below the level typically required to impart flame retardance to a molding composition, which may also serve to limit any deleterious effect in other properties which may be caused by increased levels of melamine cyanurate, such as flowability, as well as environmental concerns.

The compositions of the present invention can include other optional additives well known to those of skill on the art, such as inorganic fillers. For example, fillers such as silica, alumina, aluminosilicate, aluminum trihydrate, silicon nitride, clay, talc, mica, kaolin, calcium carbonate, wollastonite, montmorillonite, smectite, and combinations thereof are commonly present in the composition, in amounts of about 20 to 90 percent by weight, often desirably from about 50 to 90 percent by weight, and more desirably from about 60 to 90 percent by weight, based on the total weight of the composition.

A colorant such as carbon black colorant may be included in the composition of the present invention in amounts of about 0 to about 2 percent by weight, more often, from about 0.1 to about 1 percent by weight, when present.

A mold release agent such as carnauba wax, paraffin wax, polyethylene wax, ester waxes (such as EWAX commercially available from Hoechst Chemical), acid waxes (such as SWAX also commercially available from Hoechst Chemical), glycerol monostearate, and metallic stearates may be included in the composition of the present invention in amounts of from about 0 to about 2 percent by weight, more often, from about 0.2 to about 1 percent by weight, when present.

A coupling agent such as the silane type coupling agent may be included in the composition of the present invention in amounts of from about 0 to about 2 percent by weight, more often from about 0.3 to about 1 percent by weight, when present.

Ion scavengers such as magnesium aluminum carbonate hydrate, which can be obtained commercially from Kyowa Chemical Industry Co. under the trade name "DHT-4A" are suitable for use in the composition of the present invention and may be present in amounts of from about 0 to about 2 percent by weight, more often from about 0.5 to about 2 percent by weight, when present.

Examples of other additives may include stress relievers such as polyphenyleneoxide, elastomers such as powdered silicone, and adhesion promoters such as azine adhesion promoters, which may be present in amounts of from about 0 to about 3 percent by weight, when present.

While certain embodiments of the invention may include DBU in addition to the quarternary organophosphonium salt as a catalyst, such as those embodiments designed to reduce GL in circuits, it is also contemplated that additional auxiliary catalysts such as TPP, DICY and 2-methylimidazole are suitable for use in the composition of the present invention and may be present in amounts of from about 0 to about 10 percent by weight, more often from about 0.5 to about 2 percent by weight, when present.

The molding compositions can be prepared by any conventional method. For example, as is known in the art, all of the compounds may be combined and finely ground and dry blended, or the components can be mixed in a step-wise fashion to enhance homogeneous mixing. The mixture can then be treated on a hot differential roll mill such as with a large two-roll mill (one roll heated to about 90°C, and the other cooled with tap water) to produce uniform sheets, which are then ground to a powder after cooling. Alternatively, the mixture can be extruded through a twin screw extruder, as known in the art.

The molding compositions can be molded into various articles by any conventional method, e.g., by using molding apparatus such as a transfer press equipped with a multi-cavity mold for coating electronic devices. Suitable molding conditions include a temperature of about 150°C to about 200°C (preferably about 175°C to about 195°C) and a pressure of about 400 psi to about 1,500 psi.

The preferred molding compositions cure in about 0.5 minute to about 3 minutes, more preferably, about 1 minute to about 2 minutes. To determine the time for curing (i.e., minimum time needed for forming a good cull cure), the molding composition is placed in the mold press at 190°C and is inspected after a pre-set period of time (e.g., 3 minutes). If a good cure (i.e., strong and not brittle) is formed, the experiment is repeated with a shorter period of press time until the minimum time period is determined.

The molding compositions of the present invention typically demonstrate a flammability rating of UL 94V-1, more preferably, a flammability rating of UL 94V-0. The ratings are determined by measuring the total burn time of a 1/8" bar according to the UL 94 flammability test. A UL 94V-0 and a UL 94V-1 rating require the total burn time for a single bar to be less than or equal to 10 seconds and 30 seconds, respectively.

As noted above, in a particular embodiment of the invention, the epoxy resin is a multifunctional epoxy resin having a degree of branching within the resin backbone of at least three, and the crosslinking agent is a multifunctional hardener derived from phenol and having a degree of branching of at least three. Particularly desirable epoxy resins are tris-phenolmethane derived resins, such as triphenolyl methane triglycidyl ether, and particularly desirable hardeners are tris-phenolmethane derivatives. Examples of useful resins include 1-trishydroxyphenylmethane glycidyl ether, such as SLTMIEPOXY TMH574 commercially available from Sumitomo Corp., and EPPN 501H commercially available from Nippon Kayaku. An example of a useful hardener is MEH 7500 commercially available from Meiwa Kasei K.K.

Epoxy molding compounds including such multifunctional resins and hardeners having a degree of branching of at least three exhibit improved flowability, warpage and shrinkage when compared to molding compounds having multifunctional epoxy resins with traditional catalysts. Epoxy molding compounds which are based on such multifunctional epoxy resins and hardeners and which include conventional catalysts, such as triphenylphosphine or dicyandiamide, normally result in epoxy molding compounds having either low warpage or long flowability, but not both, depending on the specific catalyst involved in the reaction. Accordingly, some sacrifice in either warpage or flowability is apparent depending on the selection of the specific catalyst. It has been unexpectedly discovered through the present invention, however, that incorporating a quaternary organophosphonium salt as the catalyst for such epoxy molding compounds based on multifunctional epoxy resins and hardeners having a degree of branching of at least three provides a molding compound with a combination of long flowability and low warpage. As such, the present invention provides for a molding compound which is improved in that the combination of properties such as long flowability and low warpage are improved over the conventional catalysts, which typically lose flowability properties with improved warpage characteristics.

As noted above, the compositions of the present invention are particularly useful as molding compounds for electrical or electronic devices. In a further embodiment, the present invention provides a method for coating an electrical or electronic device. The method involves providing a molding composition as discussed above, and contacting a surface of an electronic device with the molding composition, such as by coating the composition thereon. The device including the molding composition thereon is then heated to a temperature sufficient to cure the molding composition and form a polymer on the surface of the device. Desirably, the temperature to which the molding composition is heated is typically at least 135°C, often about 165 to 195°C.

The invention will now be described by the following examples. The examples are intended to be illustrative only and are not intended to limit the scope of the invention.

The following examples of molding compositions were prepared by dry blending all of the components simultaneously and testing the compositions.

### EXAMPLES

### Example 1

Five molding compositions represented as Sample Nos. 1-5 were prepared according to the formulations as indicated in Table 1 below. Each molding composition contained an epoxy cresol novolac resin with a standard phenol novolac hardener. With the exception of Comparative Sample 1, each composition contained a phosphonium functional acetic acid ester compound as a catalyst. The weight % (wt%) indicated below were calculated based on the total weight of the compositions.

**Table 1**

| **COMPONENTS** | **SAMPLE NO.** | | | | |
|---|---|---|---|---|---|
| | **1** (comparative) | **2** | **3** | **4** | **5** |
| Silica Filler (wt%) | 82.45 | 82.23 | 82.33 | 82.43 | 82.53 |
| Epoxy Cresol Novolac Resin (wt%) | 5.68 | 5.68 | 5.68 | 5.68 | 5.68 |
| Phenol Novolac Hardener (wt%) | 0.36 | 0.18 | 0.18 | 0.18 | 0.18 |
| Flexible Type Hardener (Bisphenol-M) (wt%) | 3.25 | 3.25 | 3.25 | 3.25 | 3.25 |
| Flexible Type Hardener (xylock novolac type) (wt%) | 1.48 | 1.78 | 1.78 | 1.78 | 1.78 |
| TPP Catalyst (wt%) | 0.02 | -- | -- | -- | -- |
| DBU Catalyst (wt%) | 0.13 | -- | -- | -- | -- |
| EtTPPOAc Catalyst (wt%) | -- | 0.25 | 0.25 | 0.25 | 0.25 |
| Melamine Cyanurate Flame Retardant (Melapur MC-25 from DSM Corp.) (wt%) | 1.70 | 1.70 | 1.60 | 1.50 | 1.40 |
| Polyphenyleneoxide Stress Reliever (wt%) | 1.00 | 1.00 | 1.00 | 1.00 | 1.00 |
| Carbon Black Colorant (wt%) | 0.30 | 0.30 | 0.30 | 0.30 | 0.30 |
| Azine Adhesion Promoter (curezol 2MZ-Azine from Shikoku Fine Chemical Corp.) (wt%) | 0.02 | 0.02 | 0.02 | 0.02 | 0.02 |
| Ion Scavenger (wt%) | 1.58 | 1.58 | 1.58 | 1.58 | 1.58 |
| Waxes (wt%) | 0.98 | 0.98 | 0.98 | 0.98 | 0.98 |
| Silane Couple agents (wt%) | 1.05 | 1.05 | 1.05 | 1.05 | 1.05 |

Each of the molding compositions of Sample Nos. 1-5 were cured and tested for flammability, gel time, and shelf life stability, with the results shown in Table 2. The flammability properties of the cured compositions were determined by the total burn time of a 1/8" molded bar according to the UL 94 test. Gel time was determined through a standard testing procedure in which the compound is placed on a thermostatically-controlled hot plate which is controlled at a specified temperature. The compound is stroked with a spatula in a back-and-forth motion until it becomes stiff, with the time to stiffness representing the gel time. Shelf life stability was determined by testing the spiral flow at intervals according to a standard testing practice involving the use of a standard spiral flow mold in a transfer molding press. In the process, a sample of the composition is added to a transfer mold in a standard spiral flow mold, and the mold cycle is activated. When the mold cycle is complete, the mold is opened and the point of farthest continuous flow is recorded.

**Table 2**

| | | **SAMPLE NO.** | | | | |
|---|---|---|---|---|---|---|
| **TEST PROCEDURE** | | **1** (comparative) | **2** | **3** | **4** | **5** |
| **Flammability Test (UL 94)** | | | | | | |
| | Total Burn Time (sec) | 47 | 15 | 20 | 8 | 29 |
| | UL94 V-O Status | Fail | Pass | Pass | Pass | Fail |
| | | | | | | |
| **Gel Time (sec)** | | 26 | 24 | 24 | 24 | 25 |
| | | | | | | |

| **Shelf Life Stability** | | | | | | |
|---|---|---|---|---|---|---|
| (inches) | Spiral Flow at Room Temp | | | | | |
| | Initial | 34 | 40 | 41 | 41 | 40 |
| | 1 day | 28 | 37 | NM* | NM* | NM* |
| | 2 days | 23 (68%) | 30 (75%) | NM* | NM* | NM* |
| | | | | | | |
| | Spiral Flow at 5°C (inches) | | | | | |
| | Initial | 36 | 40 | NM* | NM* | NM* |
| | 1 week | 33 | 39 | NM* | NM* | NM* |
| | 2 weeks | 31 (86%) | 37 (93%) | NM* | NM* | NM* |

| | | | | | | |
|---|---|---|---|---|---|---|
| *NM represents not measured | | | | | | |

The results of Table 2 demonstrate that molding compositions prepared with a phosphonium functional acetic acid ester compound as a catalyst exhibit improved flame retardancy and flowability. In particular, a comparison of Sample 1 (which represents a comparative composition prepared with TPP and DBU as a catalyst) with Sample Nos. 2-4 (which represent inventive compositions prepared with EtTPPOAC as a catalyst) shows that Sample Nos. 2-4 have improved flammability ratings compared with Sample 1, which failed to achieve a UL94 V-O rating. Further, Sample No. 2 clearly exhibits improved shelf life stability as demonstrated through the increased flowability over time as compared with the comparative Sample No. 1.

### Example 2

Six molding compositions represented as Sample Nos. 6-11 were prepared according to the formulations as indicated in Table 3 below. Each molding composition contained a standard epoxy cresol novolac resin and a flexible novolac hardener, along with two known flame retardants at varying amounts. Comparative Sample Nos. 6-8 included conventional catalysts, while Sample Nos. 9-11 contained a phosphonium functional acetic acid ester compound as a catalyst. The weight % (wt%) indicated below were calculated based on the total weight of the compositions.

**Table 3**

| **COMPONENTS** | **SAMPLE NO.** | | | | | |
|---|---|---|---|---|---|---|
| | **6** (comparative) | **7** ( comparative) | **8** (comparative) | **9** | **10** | **11** |
| Silica Filler (wt%) | 80.98 | 80.98 | 80.98 | 80.86 | 80.86 | 80.86 |
| Epoxy Cresol Novolac Resin (wt%) | 6.16 | 6.27 | 6.49 | 6.16 | 6.27 | 6.49 |
| Phenol Novolac Hardener (wt%) | 0.18 | 0.18 | 0.18 | 0.18 | 0.18 | 0.18 |
| Flexible Type Hardener (xylock novolac type) (wt%) | 5.47 | 5.56 | 5.74 | 5.47 | 5.56 | 5.74 |
| TPP Catalyst (wt%) | 0.02 | 0.02 | 0.02 | -- | -- | -- |
| DBU Catalyst (wt%) | 0.11 | 0.11 | 0.11 | -- | -- | -- |
| EtTPPOAc Catalyst (wt%) | - | -- | -- | 0.25 | 0.25 | 0.25 |
| Melamine Cyanurate Flame Retardant (wt%) | 1.00 | 0.80 | 0.40 | 1.00 | 0.80 | 0.40 |
| WO₃ Flame Retardant (wt%) | 0.75 | 0.75 | 0.75 | 0.75 | 0.75 | 0.75 |
| Polyphenyleneoxide Stress Reliever (wt%) | 1.50 | 1.50 | 1.50 | 1.50 | 1.50 | 1.50 |
| Carbon Black Colorant (wt%) | 0.30 | 0.30 | 0.30 | 0.30 | 0.30 | 0.30 |
| Azine Adhesion Promoter (wt%) | 0.02 | 0.02 | 0.02 | 0.02 | 0.02 | 0.02 |
| Ion Scavenger (wt%) | 1.58 | 1.58 | 1.58 | 1.58 | 1.58 | 1.58 |
| Waxes (wt%) | 0.88 | 0.88 | 0.88 | 0.88 | 0.88 | 0.88 |
| Silane Couple agents (wt%) | 1.05 | 1.05 | 1.05 | 1.05 | 1.05 | 1.05 |

Each of the molding compositions of Sample Nos. 6-11 were cured and tested for flammability, gel time, and shelf life stability in a similar manner as in Example 1, with the results shown in Table 4.

**Table 4**

| | | **SAMPLE NO.** | | | | | |
|---|---|---|---|---|---|---|---|
| **TEST PROCEDURE** | | **6** (comparative) | **7** (comparative) | **8** (comparative) | **9** | **10** | **11** |
| **Flammability Test (UL 94)** | | | | | | | |
| | Total Burn Time (sec) | 44 | 21 | 16 | | 3 | 13 |
| | UL94 V-O Status | Fail | Fail | Pass | Pass | Pass | Pass |
| | | | | | | | |
| **Gel Time (sec)** | | 24 | 23 | 24 | 21 | 21 | 22 |
| | | | | | | | |

| **Flowability** | | | | | | | |
|---|---|---|---|---|---|---|---|
| | Spiral Flow at Room | 35 | 36 | 41 | 37 | 37 | 41 |
| Temp (inches) | | | | | | | |

The results of Table 4 demonstrate that molding compositions prepared with a phosphonium functional acetic acid ester compound as a catalyst exhibit improved flame retardancy and flowability. In particular, a comparison of Sample Nos. 6-8 (which represent comparative compositions prepared with TPP and DBU as a catalyst) with Sample Nos. 9-11 (which represent inventive compositions prepared with EtTPPOAC as a catalyst) shows a decrease in total burn time for the samples including EtTPPOAC, a decrease in gel time, and at least the same or improved flowability.

### Example 3

Six molding compositions represented as Sample Nos. 12-17 were prepared according to the formulations as indicated in Table 5 below. Each molding composition contained a standard epoxy cresol novolac resin and a flexible novolac hardener, along with melamine cyanurate as a flame retardant at varying amounts. Comparative Sample Nos. 12-14 included conventional catalysts, while Sample Nos. 15-17 contained a phosphonium functional acetic acid ester compound as a catalyst. The weight % (wt%) indicated below were calculated based on the total weight of the compositions.

**Table 5**

| **COMPONENTS** | **SAMPLE NO.** | | | | | |
|---|---|---|---|---|---|---|
| | **12** comparative | **13** comparative | **14** comparative | **15** | **16** | **17** |
| Silica Filler (wt%) | 83.68 | 83.68 | 83.68 | 83.57 | 83.57 | 83.57 |
| Epoxy Cresol Novolac Resin (wt%) | 5.53 | 5.64 | 5.75 | 5.53 | 5.64 | 5.75 |
| Phenol Novolac Hardener (wt%) | 0.18 | 0.18 | 0.18 | 0.18 | 0.18 | 0.18 |
| Flexible Type Hardener (xylock novolac type) (wt%) | 4.84 | 4.93 | 5.02 | 4.84 | 4.93 | 5.02 |
| TPP Catalyst (wt%) | 0.02 | 0.02 | 0.02 | -- | -- | -- |
| DBU Catalyst (wt%) | 0.12 | 0.12 | 0.12 | -- | -- | -- |
| EtTPPOAc Catalyst (wt%) | - | -- | -- | 0.25 | 0.25 | 0.25 |
| Melamine Cyanurate Flame Retardant (wt%) | 0.80 | 0.60 | 0.40 | 0.80 | 0.60 | 0.40 |
| Polyphenyleneoxide Stress Reliever (wt%) | 1.00 | 1.00 | 1.00 | 1.00 | 1.00 | 1.00 |
| Carbon Black Colorant (wt%) | 0.30 | 0.30 | 0.30 | 0.30 | 0.30 | 0.30 |
| Azine Adhesion Promoter (wt%) | 0.02 | 0.02 | 0.02 | 0.02 | 0.02 | 0.02 |
| Ion Scavenger (wt%) | 1.58 | 1.58 | 1.58 | 1.58 | 1.58 | 1.58 |
| Waxes (wt%) | 0.88 | 0.88 | 0.88 | 0.88 | 0.88 | 0.88 |
| Silane Couple agents (wt%) | 1.05 | 1.05 | 1.05 | 1.05 | 1.05 | 1.05 |

Each of the molding compositions of Sample Nos. 12-17 were cured and tested for flammability, gel time, and shelf life stability in a similar manner as in Example 1, with the results shown in Table 6.

**Table 6**

| | | **SAMPLE NO.** | | | | | |
|---|---|---|---|---|---|---|---|
| **TEST PROCEDURE** | | **12** comparative | **13** comparative | **14** comparative | **15** | **16** | **17** |
| **Flammability Test (UL 94)** | | | | | | | |
| | Total Burn Time (sec) | 6 | 5 | 23 | 2 | 1 | 15 |
| | UL94 V-O Status | Pass | Pass | Pass | Pass | Pass | Pass |
| | | | | | | | |
| **Gel Time (sec)** | | 21 | 22 | 22 | 20 | 21 | 20 |
| | | | | | | | |
| **Flowability** | | | | | | | |
| | Spiral Flow at Room | 33 | 33 | 34 | 33 | 32 | 33 |
| Temp (inches) | | | | | | | |

The results of Table 6 demonstrate that molding compositions prepared with a phosphonium functional acetic acid ester compound as a catalyst exhibit flame retardancy with a low level of additional flame retardant, without sacrifice in the flowability of the composition. In particular, a comparison of Sample Nos. 12-14 (which represent comparative compositions prepared with TPP and DBU as a catalyst) with Sample Nos. 15-17 (which represent inventive compositions prepared with EtTPPOAC as a catalyst) shows a decrease in total burn time for the samples including EtTPPOAC, and a slight decrease in gel time, without any significant change in flowability.

### Example 4

A molding composition according to the present invention was prepared according to the following formulation:

**Table 7**

| **COMPONENTS** | **SAMPLE NO.** | |
|---|---|---|
| | **18** | **19** |
| Silica Filler (wt%) | 80.59 | 80.05 |
| Epoxy Cresol Novolac Resin (wt%) | 6.09 | 7.89 |
| Phenol Novolac Hardener (wt%) | 0.18 | 3.73 |
| Flexible Type Hardener | 5.26 | -- |
| (xylock novolac type, p-bis(medioxy-methyl)benzenephenol copolymer) (wt%) | | |
| Flexible Type Hardener | -- | 1.56 |
| (DEH-85 from Dow Chemical) (wt%) | | |
| EtTPPOAc Catalyst (wt%) | 0.23 | 0.24 |
| Melamine Cyanurate Flame Retardant (wt%) | 2.80 | 2.80 |
| Polyphenyleneoxide Stress Reliever (wt%) | 1.02 | 1.10 |
| Carbon Black Colorant (wt%) | 0.30 | 0.35 |
| Azine Adhesion Promoter (wt%) | 0.02 | 0.03 |
| Ion Scavenger (wt%) | 1.58 | 0.80 |
| Waxes (wt%) | 0.88 | 0.75 |
| Silane Couple agents (wt%) | 1.05 | 0.70 |
| TOTAL | 100.0 | 100.0 |

The molding compositions of Sample Nos. 18 and 19 were cured and tested for flammability, gel time, and shelf life stability as in Example 1 above. The molding composition of Sample Nos. 18 and 19 passed flammability testing with a UL 94 V-O rating, and exhibited excellent gel time and flowability properties for shelf life stability.

### Example 5

Three molding compositions represented as Sample Nos. 20-22 were prepared according to the formulations as indicated in Table 8 below. Each molding composition contained a tris-phenolmethane derived multifunctional epoxy resin and a tris-phenolmethane derived multifunctional hardener. Comparative Sample Nos. 20-21 included conventional catalysts, while Sample No. 22 contained a phosphonium functional acetic acid ester compound as a catalyst. The weight % (wt%) indicated below were calculated based on the total weight of the compositions.

**Table 8**

| **COMPONENTS** | | **SAMPLE NO.** | | |
|---|---|---|---|---|
| | | **20** | **21** | **22** |
| Silica Filler (wt%) | | 88.70 | 88.35 | 88.67 |
| Biphenyl Epoxy Resin (wt%) | | 2.70 | 2.69 | 2.70 |
| | (Yuka Shell Epoxy K.K. RSF 1407) | | | |
| Multifunctional Epoxy Resin (wt%) | | 2.59 | 2.58 | 2.59 |
| | (Nippon Kayaku EPPN 501H) | | | |
| Multifunctional Hardener (wt%) | | 2.76 | 2.75 | 2.76 |
| | (Meiwa Kasei K.K. MEH 7500) | | | |
| TPP Catalyst (wt%) | | 0.10 | -- | -- |
| Dicyandiamide Catalyst (wt%) | | -- | 0.36 | -- |
| Amine Hardener (wt%) | | -- | 0.13 | -- |
| | (Resolution Performance Products EPICURE P-101) | | | |
| EtTPPOAc Catalyst (wt%) | | -- | -- | 0.13 |
| Melamine Cyanurate Flame Retardant (wt%) | | 0.37 | 0.37 | 0.37 |
| Elastomer (wt%) | | 0.72 | 0.71 | 0.72 |
| | (powdered silicone) | | | |
| Carbon Black Colorant (wt%) | | 0.24 | 0.24 | 0.24 |
| Ion Scavenger (wt%) | | 0.42 | 0.42 | 0.42 |
| Waxes (wt%) | | 0.58 | 0.58 | 0.57 |
| Silane Couple agents (wt%) | | 0.83 | 0.82 | 0.83 |

Each of the molding compositions of Sample Nos. 20-22 were cured and tested for gel time and flowability as in Example 1 above, as well as shrinkage and warpage. Shrinkage was determined based on ASTM-D955-89. Warpage was determined using a standard test involving molding the material through transfer molding a 29 mm² x 1.25 mm mold cap onto a bare substrate having the following description: Unimicron VT52 board, 35 mm² part, 5 parts per board, 4 layer, BT laminate, T_{g} 190°C, 0.56 mm thick, Solder Mask Taiyo PSR-4000 AUS303. The warpage is measured by taking to co-planarity value obtained on an AkroMetrics TherMoire PS88 with a 100 line per inch grating Shadow Moire interferometer at room temperature. The results are shown in Table 9.

**Table 9**

| **COMPONENTS** | | **SAMPLE NO.** | | |
|---|---|---|---|---|
| **TEST PROCEDURE** | | **20** | **21** | **22** |
| **Gel Time at 175°C (sec)** | | 20 | 15 | 22 |
| | | | | |
| **Flow at 175°C (inches)** | | 31 | 24 | 42 |
| | | | | |
| **Shrinkage (%)** | | | | |
| | As Molded | 0.14 | 0.13 | 0.14 |
| | PC 1 hour at 175°C | 0.11 | 0.09 | 0.13 |
| | | | | |
| **Warpage, 35 mm part** | | | | |
| | As Molded | 3.1 | 2.3 | 3.5 |
| | PC 1 hour at 175°C | 2.5 | 2 | 2.7 |
| | | | | |

The results of Table 9 demonstrate that molding compositions prepared with a phosphonium functional acetic acid ester compound as a catalyst exhibit excellent flowability, and provide the best combination of warpage and flow characteristics when compared with molding compositions prepared with conventional catalysts.

### Example 6

A molding compound was prepared including a catalyst system which combined DBU and EtTPPOAc as a curing catalyst. In particular, a molding composition was prepared according to the following formulation set forth in Table 10:

**Table 10**

| **COMPONENTS** | | **SAMPLE NO. 23** |
|---|---|---|
| Silica Filler (wt%) | | 79.55 |
| Epoxy Cresol Novolac Resin (wt%) | | 7.25 |
| Flexible Type Hardener (wt%) | | 5.18 |
| | (zylock novolac type) | |
| Phenol Novolac Hardener (wt%) | | 1.27 |
| EtTPPOAc Catalyst (wt%) | | 0.17 |
| DBU Catalyst (wt%) | | 0.18 |
| Melamine Cyanurate Flame Retardant (wt%) | | 3.00 |
| Zinc Oxide | | 0.40 |
| Zinc Borate | | 0.50 |
| Polyphenyleneoxide Stress Reliever (wt%) | | 0.6 |
| Carbon Black | | 0.30 |
| Ion Scavenger (wt%) | | 0.30 |
| Waxes | | 0.57 |
| Azine Adhesion Promoter | | 0.03 |
| Silanes | | 0.70 |

The composition was used to prepare a set of six logic devices as test vehicles, with the logic devices constructed of die comprising a 574LS00 Quad 2-Input NAND Gate passivated with a SiN₃ layer. The die were assembled using QMI 505MT die attach, an bismaleimide based die attach material commercially available from Henkel Corporation, and wire bonded with 1 mil gold wire onto a 20 lead SOIC wide-body lead frame having a NiPdAu plating.

The devices were tested for DC parametric testing using a GenRad 1731A, and functional testing both before and after the gate leakage exposure. Prior to the GL test, the devices were submitted for initial functional and parametric screening. The parametric testing was performed at room temperature. The initial test (+Icc) is the current to the DUT from the positive power supply with all inputs grounded and all outputs open. Two functional tests are then performed: one using the minimum power supplies value and another using the maximum. The remaining tests check each individual input and output pin for voltages and current levels by forcing voltage and measuring current or by forcing currents and measuring voltages.

If the devices pass this testing, they were then subjected to GL testing. The devices were first subjected to a soak temperature of about 160°C for about 15 minutes. GL testing was then conducted by subjecting the devices to a temperature of about 160°C with a bias voltage of 500 volts DC applied. The temperature was then ramped down to 100°C while the bias voltage was still applied for a period of 7 - 10 minutes. Three of the devices were stressed at a positive GL exposure and three were stressed with a negative GL exposure. After the electric field-induced GL exposure the parts were again screened for parametric tests. The results are shown in Table 10.

**Table 10**

| | |
|---|---|
| Spiral flow (inches) | 36 |
| Gel Time (seconds) | 14.5 |
| GL Test | PASS |
| Permitivity | 45 |
| 0.3 Hz, 160°C (Post Mold Cure) | |
| Ionic Conditions | 59 |
| 0.3 Hz, 200°C, (Post Mold Cure) | |

## Claims

1. A molding compound for a semiconductor comprising:
a) an epoxy resin,
b) a curing agent for the epoxy resin;
c) a catalyst for promoting reaction of the epoxy resin and the curing agent, said catalyst comprising a quaternary organophosphonium salt and a tertiary amines and
d) optionally, a flame retardant compound.

2. The molding compound of claim 1, wherein the quaternary organophosphonium salt comprises an organophosphonium functional acetic acid ester compound.

3. The molding compound of claim 2, wherein the quaternary organophosphonium salt is ethyl triphenyl phosphonium acid acetate.

4. The molding compound of claim 1, wherein the epoxy resin is present in an amount of from about 1 percent to about 25 percent by weight, based on the total weight of the composition.

5. The molding compound of claim 1, wherein curing agent is present in an amount of from about I percent to about 10 percent by weight based on the total weight of the composition.

6. The molding compound of claim 1, wherein the catalyst is present in at least an amount sufficient to catalytically effect crosslinking of the epoxy resin and the curing agent when the composition is heated to a temperature of at least 135°C

7. The molding compound of claim 1, wherein the quaternary organophosphonium salt is present in at least an amount sufficient to provide improved flame retardance to the composition after curing thereof, compared to a similar composition that does not contain a quaternary organophosphonium salt.

8. The molding compound of claim 1, wherein the catalyst further comprises 1, 8-diazabicyclo[5.4.0]undec-7-ene (DBU).

9. The molding compound of claim 1, wherein the flame retardant compound comprises a cyanurate functional compound.

10. The molding compound of claim 9, wherein the cyanurate functional compound is melamine cyanurate.

11. The molding compound of claim 10, wherein the melamine cyanurate is present in an amount less than about 3.0 percent by weight, based on the total weight of the composition.

12. The molding compound of claim 1, further comprising an inorganic filler component.

13. The molding compound of claim 12, wherein the inorganic filter component is present in an amount of from about 20 percente to about 90 percent based on the total weight of the composition.

14. The molding compound of claim 12, wherein the inorganic filter component is selected from the group consisting of silica, alumina aluminosilicate, aluminium trihydrate, silicon nitride, clay, talc, mica, kaolin, calcium carbonate, wollastonite, montmorillonite, smectite, and combinations thereof.

15. The molding compound of claim 1, wherein the epoxy resin is selected from the group consisting of bisphenol A type epoxy resins, novolac type epoxy resins, alicyclic epoxy resins, glycidyl type epoxy resins, biphenyl type epoxy resins, naphthalene ring-containing epoxy resins, cyclopentadiene-containing epoxy resins, polyfunctional epoxy resins, and combinations thereof

16. The molding compound of claim 1, wherein the curing agent is selected from the group consisting of phenol novolac type hardener, cresol novolac type hardener, dicyclopentadiene phenol type hardener, limonene type hardener, flexible type hardener, anhydrides, and combinations thereof.

17. The molding compound of claim 1, wherein the curing agent comprises a flexible hardener having a hydroxyl equivalent weight greater than about 150.

18. The molding compound of claim 1, wherein the epoxy resin comprises a multifunctional epoxy resin derived from phenol and having a degree of branching of at least three and wherein the crosslinking agent is derived from phenol and has a degree of branching of at least three.

19. The molding compound of claim 18, wherein the epoxy resin comprises triphenylol methane triglycidyl other epoxy resin, and the crosslinking agent comprises a phenolic hardener derived from tris-phenol methane.

20. A method of providing a flame retardant polymer for a semiconductor comprising:
providing an epoxy molding composition comprising an epoxy resin, a crosslinking agent for the epoxy resin, a cyanurate functional compound a quaternary organophosphonium salt; and a tertiary amine; and
heating the epoxy molding composition a temperature sufficient to cause the quaternary organophosphonium salt and the tertiary amine to catalytically effect crosslinking of the epoxy resin and the crosslinking agent.

21. The method of claim 20, wherein the cyanurate functional compound is melamine cyanurate.

22. The method of claim 20, wherein the quaternary organophosphonium salt is ethyl triphenyl phosphonium acid acetate.

23. The method of claim 20, wherein the quaternary organophosphonium salt is provided in the molding composition in an amount of from about 0.1 percent to about 1 percent by weight, based on the total weight of the composition.

24. The method of claim 20, wherein the temperature ranges from about 135°C to about 195°C.

25. A method of reducing gate leakage in an electrical or electronic device comprising encapsulating the device with a molding composition comprising an epoxy resin, a crosslinking agent for the epoxy resin and a catalyst comprising a quaternary organophosphonium salt, and a tertiary amine.

26. The method of 25, wherein the quaternary organophosphonium salt is ethyl triphenyl phosphonium acid acetate.

27. The method of claim 25, wherein the catalyst comprises 1,8-diazabicyclo[5.4.0]undec-7-ene (DBU).

28. The method of claim 25 wherein encapsulating comprises the steps of a) providing the molding composition; b) coating a surface of the device with the molding composition; and c) heating the molding composition to a temperature suffucient to cure the molding composition and form a polymer on a surface of the device.

## Patentansprüche

1. Eine Formmasse für einen Halbleiter enthaltend:
a) ein Epoxidharz,
b) ein Härtungsmittel für das Epoxidharz,
c) einen Katalysator zur Begünstigung der Reaktion des Epoxidharzes und des Härtungsmittels. wobei der Katalysator ein quaternäres Organophosphoniumsalz und ein tertiäres Amin enthält, und
d) gegebenenfalls eine flammhemmende Verbindung.

2. Die Formmasse nach Anspruch 1, wobei das quaternäre Organophosphoniumsalz eine organophosphoniumfunktionelle Essigsäureesterverbindung umfasst.

3. Die Formmasse nach Anspruch 2, wobei das quaternäre Organophosphoniumsalz Ethyltriphenylphosphoniumsäureacetat ist.

4. Die Formmasse nach Anspruch 1, wobei das Epoxidharz in einer Menge von etwa 1 Gew.-% bis etwa 25 Gew.-%. bezogen auf das Gesamtgewicht der Zusammensetzung vorliegt.

5. Die Formmasse nach Anspruch 1, wobei das Härtungsmittel in einer Menge von etwa 1 Gew.-% bis etwa 10 Gew.-%, bezogen auf das Gesamtgewicht der Zusammensetzung vorliegt.

6. Die Formmasse nach Anspruch 1, wobei der Katalysator wenigstens in einer Menge vorliegt, die ausreicht, um das Vernetzen des Epoxidharzes und des Härtungsmittels katalytisch zu bewirken, wenn die Zusammensetzung auf eine Temperatur von wenigstens 135°C erhitzt wird.

7. Die Formmasse nach Anspruch 1, wobei das quaternäre Organophosphoniumsatz wenigstens in einer Menge vorliegt, die ausreicht, um der Zusammensetzung nach deren Aushärtung eine verbesserte Flammhemmung zu verleihen, verglichen mit einer ähnlichen Zusammensetzung, die kein quaternäres Organophosphoniumsalz enthält.

8. Die Formmasse nach Anspruch 1, wobei der Katalysator ferner 1,8-Diazabicyclo[5.4.0]undec-7-en (DBU) umfasst.

9. Die Formmasse nach Anspruch 1, wobei die flammhemmende Verbindung eine cyanuratfunktionelle Verbindung umfasst.

10. Die Formmasse nach Anspruch 9, wobei die cyanuratfunktionelle Verbindung Melamincyanurat ist.

11. Die Formmasse nach Anspruch 10, wobei das Melamincyanurat in einer Menge von weniger als etwa 3.0 Gew.-% vorliegt, bezogen auf das Gesamtgewich der Zusammensetzung.

12. Die Formmasse nach Anspruch 1, die ferner eine anorganische Füllstoffkomponente enthält.

13. Die Formmasse nach Anspruch 12, wobei die anorganische Füllstoffkomponente in einer Menge von etwa 20 Prozent bis etwa 90 Prozent bezogen auf das Gesamtgewicht der Zusammensetzung vorliegt.

14. Die Formmasse nach Anspruch 12, wobei die anorganische Füllstoffkomponente ausgewählt ist aus der Gruppe, bestehend aus Siliciumdioxid, Aluminiumoxid, Aluminosilicat, Aluminiumtrihydrat, Siliciumnitrid, Ton, Talk, Glimmer, Kaolin Calciumcarbonat, Wollastonit, Montmorillonit, Smektit und Kombinationen daraus.

15. Die Formmasse nach Anspruch 1, wobei des Epoxidharz ausgewählt ist aus der Gruppe, bestehend aus Epoxidharzen vom Bisphenol-A-Typ. Epoxidharzen vom-Novolak-Typ, alicyclischen Epoxidharzen, Epoxidharzen vom Glycidyl-Typ. Epoxidharzen vom Biphenyl-Typ naphthalinringhaltigen Epoxidharzen cyclopentadienhaltigen Epoxidharzen, polyfunktionellen Epoxidharzen und Kombinationen daraus.

16. Die Formmasse nach Anspruch 1, wobei das Härtungsmittel ausgewählt ist aus der Gruppe, bestehend aus Härter vom Phenol-Novolak-Typ, Härter vom Kresol-Novolak-Typ, Härter vom Dicyclopentadlen-Phenol-Typ, Härter vom Limonen-Typ, Härter vom flexiblen Typ, Anhydriden und Kombinationen daraus.

17. Die Formmasse nach Anspruch 1, wobei das Härtungsmittel einen flexiblen Härter mit einem Hydroxyläquivalentgewicht von mehr als etwa 150 umfasst.

18. Die Formmasse nach Anspruch 1, wobei das Epoxidharz ein multifunktionelles Epoxidharz umfasst, das von Phenol hergeleitet ist und einen Verzweigungsgrad von weinigstens drei besitzt, und wobei das Vernetzungsmittel von Phenol hergeleitet ist und eine Verzweigungsgrad von wenigstens drei besitzt.

19. Die Formmasse nach Anspruch 18, wobei das Epoxidharz Triphenylolmethantriglycidylether-Epoxidharz umfasst und das Vernetzungemittel einen von Trisphenolmethan hergeleiteten phenolischen Härter umfasst.

20. Ein Verfahren zur Bereitstellung eines flammhemmenden Polymers für einen Halbleiter, umfassend:
Bereitstellen einer Expoxid-Formmasse; enthaltend ein Epoxidharz, ein Vernetzungsmittel für das Epoxidharz, eine cyanuratfunktionelle Verbindung, ein quaternäres Organophosphoniumsalz und ein tertiäres Amin, und
Erhitzen der Epoxid-Formmasse auf eine ausreichende Temperatur, damit das quaternäre Organophosphoniumsalz und das tertiäre Amin die Vernetzung des Epoxidharzes und des Vernetzungsmittels katalytisch bewirken.

21. Das Verfahren nach Anspruch 20, wobei die cyanuratfunktionelle Verbindung Melamincyanurat ist.

22. Das Verfahren nach Anspruch 20, wobei das quaternäre Organophosphoniumsalz Ethyltriphenylphosphoniumsäureacetat, ist.

23. Das Verfahren nach Anspruch 20, wobei das quaternäre Organophosphoniumsatz in der Formmasse in einer Menge von etwa 0,1 Gew.-% bis etwa 1 Gew.-%, bezogen auf das Gesamtgewicht der Zusammensetzung, zur Verfügung gestellt wird.

24. Das Verfahren nach Anspruch 20, wobei die Temperatur von etwa 135°C bis etwa 195°C reicht.

25. Ein Verfahren zur Gate-Leakage-Verringerung in einer elektrischen oder elektronischen Einrichtung umfassend die Einkapselung der Einrichtung mit einer Formmasse, die ein Epoxidharz, ein Vernetzungsmittel für das Epoxidharz und einen Katalysator, der ein quaternäres Organophosphoniumsalz und ein tertiäres Amin umfasst, enthält.

26. Das Verfahren nach Anspruch 25, wobei das quaternäre Organophosphoniumsalz Ethyltriphenylphosphoniumsäureacetat ist.

27. Das Verfahren nach Anspruch 25, wobei der Katalysator 1,8-Diazabicyclo-[5.4.0]undec-7-en (D8U) umfasst.

28. Das Verfahren nach Anspruch 25, wobei die Einkapselung die Schritte umfasst: a) Bereitstellen der Formmasse, b) Beschichten einer Oberfläche der Einrichtung mit der Formmasse und c) Erhitzen der Formmasse auf eine Temperatur, die ausreicht um die Formmasse zu härten und auf der Oberfläche der Einrichtung ein Polymer zu bilden.

## Revendications

1. Composé de moulage pour semi-conducteur, comprenant :
a) une résine époxy ;
b) un agent durcisseur de la résine époxy ;
c) un catalyseur permettant de promouvoir la réaction de la résine époxy et de l'agent durcisseur, ledit catalyseur comportant un sel d'organophosphonium quaternaire et une amine tertiaire, et
d) en option, un composé ignifugeant.

2. Composé de moulage de la revendication 1, dans lequel le sel d'organophosphonium quaternaire comprend un composé ester d'acide acétique à fonction organophosphonium.

3. Composé de moulage de la revendication 2, dans lequel le sel d'organophosphonium quaternaire est l'acide-acétate d'éthyltriphénylphosphonium.

4. Composé de moulage de la revendication 1, dans lequel la résine époxy est présente dans une quantité comprise entre environ 1 pour-cent et environ 25 pour-cent en poids, sur la base du poids total de la composition.

5. Composé de moulage de la revendication 1, dans lequel l'agent durcisseur est présent dans une quantité comprise entre environ 1 pour-cent et environ 10 pour-cent en poids, sur la base du poids total de la composition.

6. Composé de moulage de la revendication 1, dans lequel le catalyseur est présent dans au moins une quantité suffisante pour effectuer par voie catalytique la réticulation de la résine époxy et de l'agent durcisseur lorsque la composition est chauffée à une température d'au moins 135 °C.

7. Composé de moulage de la revendication 1, dans lequel le sel d'organophosphonium quaternaire est présent dans au moins une quantité suffisante pour fournir à la composition une ignifugation améliorée après son durcissement, en comparaison avec une composition similaire mais qui ne contient pas de sel d'organophosphonium quaternaire.

8. Composé de moulage de la revendication 1, dans lequel le catalyseur comprend en outre du 1,8-diazabicyclo[5.4.0]undéc-7-ène (DBU).

9. Composé de moulage de la revendication 1, dans lequel le composé ignifugeant comprend un composé fonctionnel de cyanurate.

10. Composé de moulage de la revendication 9, dans lequel le composé fonctionnel de cyanurate est le cyanurate de mélamine.

11. Composé de moulage de la revendication 10, dans lequel le cyanurate de mélamine est présent dans une quantité inférieure à environ 3,0 pour-cent en poids, sur la base du poids total de la composition.

12. Composé de moulage de la revendication 1, comprenant en outre un composant de charge inorganique.

13. Composé de moulage de la revendication 12, dans lequel le composant de charge inorganique est présent dans une quantité comprise entre environ 20 pour-cent et environ 90 pour-cent, sur la base du poids total de la composition.

14. Composé de moulage de la revendication 12, dans lequel le composant de charge inorganique est sélectionné dans le groupe composé de la silice, de l'alumine, de l'aluminosilicate, de l'aluminium trihydraté, du nitrure de silicium, de l'argile, du talc, du mica, du kaolin, du carbonate de calcium, de la wollastonite, de la montmorillonite, de la smectite et de leurs combinaisons.

15. Composé de moulage de la revendication 1, dans lequel la résine époxy est sélectionnée dans le groupe composé des résines époxy de type bisphénol A, des résines époxy de type novolaque, des résines époxy alicycliques, des résines époxy de type glycidyle, des résines époxy de type biphényle, des résines époxy contenant un cycle naphtalène, des résines époxy contenant un cyclopentadiène, des résines époxy polyfonctionnelles et de leurs combinaisons.

16. Composé de moulage de la revendication 1, dans lequel l'agent durcisseur est sélectionné dans le groupe composé d'un durcisseur de type novolaque phénol, d'un durcisseur de type novolaque crésol, d'un durcisseur de type dicyclopentadiène-phénol, d'un durcisseur de type limonène, d'un durcisseur de type flexible, d'anhydrides et de leurs combinaisons.

17. Composé de moulage de la revendication 1, dans lequel l'agent durcisseur comprend un durcisseur flexible ayant un poids en équivalent hydroxyle supérieur à environ 150.

18. Composé de moulage de la revendication 1, dans lequel la résine époxy comprend une résine époxy multifonctionnelle dérivée du phénol et ayant un degré de ramification d'au moins trois, et dans lequel l'agent de réticulation est dérivé du phénol et a un degré de ramification d'au moins trois.

19. Composé de moulage de la revendication 18, dans lequel la résine époxy comprend une résine époxy de triglycidyléther de triphénylolméthane, et l'agent de réticulation comprend un durcisseur phénolique dérivé du tris-phénol-méthane.

20. Procédé de réalisation d'un polymère ignifugeant pour semi-conducteur, comprenant les étapes consistant à :
fournir une composition de moulage époxy comprenant une résine époxy, un agent de réticulation de la résine époxy, un composé fonctionnel de cyanurate, un sel d'organophosphonium quaternaire ; et une amine tertiaire; et
chauffer la composition de moulage époxy à une température suffisante pour que le sel d'organophosphonium quaternaire et l'amine tertiaire effectuent par voie catalytique la réticulation de la résine époxy et de l'agent de réticulation.

21. Procédé selon la revendication 20, dans lequel le composé fonctionnel de cyanurate est le cyanurate de mélamine.

22. Procédé selon la revendication 20, dans lequel le sel d'organophosphonium quaternaire est l'acide-acétate d'éthyltriphénylphosphonium.

23. Procédé selon la revendication 20, dans lequel le sel d'organophosphonium quaternaire est prévu dans la composition de moulage dans une quantité comprise entre environ 0,1 pour-cent et environ 1 pour-cent en poids, sur la base du poids total de la composition.

24. Procédé selon la revendication 20, dans lequel la température est comprise entre environ 135 °C et environ 195 °C.

25. Procédé de réduction d'une fuite de grille dans un dispositif électrique ou électronique, comprenant l'encapsulation du dispositif avec une composition de moulage comprenant une résine époxy, un agent de réticulation de la résine époxy et un catalyseur comportant un sel d'organophosphonium quaternaire, et une amine tertiaire.

26. Procédé de la revendication 25, dans lequel le sel d'organophosphonium quaternaire est l'acide-acétate d'éthyltriphénylphosphonium.

27. Procédé de la revendication 25, dans lequel le catalyseur comprend du 1,8-diazabicyclo[5.4.0]undéc-7-ène (DBU).

28. Procédé de la revendication 25, dans lequel l'encapsulation comprend les étapes consistant à a) fournir la composition de moulage ; b) enrober une surface du dispositif avec la composition de moulage ; et c) chauffer la composition de moulage à une température suffisante pour durcir la composition de moulage et former un polymère sur une surface du dispositif.
